# EUROPEAN PATENT APPLICATION

(11) **EP 4 722 846 A1**
(43) Date of publication of application: **08.04.2026**
(21) Application number: 24814937.9
(22) Date of filing: 21.03.2024
(51) Int. Cl.: G05D 3/00, G02F 1/13, H01L 21/68, H01L 21/677, B32B 37/00

(54) **BONDED MEMBER MANUFACTURING DEVICE AND BONDED MEMBER MANUFACTURING METHOD**

(30) Priority: 26.05.2023 JP 2023087197
(71) Applicant: Origin Company, Limited, Saitama-shi Saitama 338-0823 (JP)
(72) Inventor: MATSUMOTO, Yutaka, Saitama-shi, Saitama 338-0823 (JP); SUDO, Masahiro, Saitama-shi, Saitama 338-0823 (JP); IINO, Shota, Saitama-shi, Saitama 338-0823 (JP)
(74) Representative: Wallin, Nicholas James
(86) International application number: PCT/JP2024/011084
(87) International publication number: WO 2024/247450

(57) **Abstract**

This bonded member manufacturing device is provided with: a support member having a placement surface; a camera; a stage that supports a first member when bonding the first member to a second member; a movement device that moves the support member; and a control device. The position of the first member placed at a standard position on the placement surface is stored in advance, and the control device determines the deviation, from the standard position, of the first member as photographed by the camera. When moving the first member to a transfer position, the control device causes the support member to be moved to a position where the determined deviation is corrected and the first member reaches the appropriate position. In a manufacturing method for the bonded member, the deviation, from the standard position, of the first member as photographed by the camera is determined, the deviation is corrected such that the first member is moved to the appropriate position, and the first member is transferred to the stage and bonded to the second member.

## Description

### Technical Field

The present disclosure relates to a bonded object manufacturing apparatus and a method for manufacturing a bonded object, and particularly relates to a bonded object manufacturing apparatus and a method for manufacturing a bonded object that involve alignment of objects to be bonded.

### Background Art

For example, in a process of manufacturing a liquid crystal panel, a liquid crystal substrate and a protective glass are bonded together with an adhesive interposed therebetween. When two objects are bonded together via a material such as an adhesive, it is typically necessary to align the relative positions of the two objects. As such alignment, there is a technique in which one of the objects placed on an object placement table that can be driven by a driving device is imaged by a plurality of CCD cameras, and the position of the object placement table is adjusted by driving the driving device based on images obtained by the CCD cameras (see, for example, Japanese Patent No. 5486703).

### SUMMARY OF INVENTION

### Technical Problem

The technique disclosed in the Patent Literature 1 performs alignment of two objects at a location where the bonding is performed. However, if the bonding location is, for example, the inside of a vacuum chamber, a special measure may be required to install a camera at the bonding location. In view of such circumstances, alignment is sometimes performed before the objects are moved to the bonding location. This pre-alignment is performed by a dedicated alignment automatic stage provided with a plurality of cameras. In this case, the objects are conveyed near the automatic stage by a conveying arm, transferred to and aligned on the automatic stage, transferred to another conveying arm that moves in a predetermined motion from the automatic stage to the bonding location, and conveyed to the bonding location. Since the subsequent conveying arm moves in a predetermined motion, when it receives the objects aligned on the automatic stage, it can deliver the objects to a proper position when it moves to the bonding location. However, in such pre-alignment, a dedicated alignment automatic stage and conveying arms arranged in front of and behind the stage are used, resulting in an increased number of components and a complicated mechanism.

In view of the above-described problems, the present disclosure relates to a bonded object manufacturing apparatus with a simplified configuration, and a method for manufacturing a bonded object.

### Solution to Problem

A bonded object manufacturing apparatus according to a first aspect of the disclosure includes: a support member having a placement surface, the placement surface being configured to support a first object on a surface thereof; a camera configured to image the first object placed on the placement surface; a stage configured to receive the first object from the support member and support first object when the first object is bonded to a second object; a moving device configured to move the support member such that the placement surface moves on a virtual plane identical to the placement surface, the moving device being configured to move the support member such that the placement surface passes through a placement position at which the first object is placed on the placement surface, an imaging position at which the first object is imaged by the camera, and a transfer position at which the first object is transferred to the stage; and a controller configured to control movement of the support member by the moving device and imaging of the first object by the camera, wherein: the controller has stored in advance a position of the first object placed at a standard position on the placement surface located at the imaging position, and the controller is configured to control the moving device and the camera such that the controller determines, based on imaging of the first object by the camera when the placement surface supporting the first object is located at the imaging position, a deviation of the first object from the standard position, and, when the placement surface has moved to the transfer position, the support member is moved to a position at which the deviation is corrected and the first object placed on the placement surface is positioned at a proper position; and the proper position is a position of the first object when the placement surface supporting the first object at the standard position has reached the transfer position along a normal trajectory, the proper position being a position at which the first object, transferred from the support member to the stage and supported by the stage, is aligned with the second object.

With this configuration, it is possible to detect and correct a positional deviation of the first object and transfer the first object to the stage without removing the first object from the support member during the period from when the first object is supported by the support member to when it is transferred to the stage. Accordingly, a dedicated automatic alignment stage and conveying arms disposed in front of and behind the stage, which have been conventionally used, become unnecessary, and the apparatus configuration can be simplified.

In addition, as for a bonded object manufacturing apparatus according to a second aspect of the disclosure, in the bonded object manufacturing apparatus according to the first aspect of the disclosure, the moving device may include a first moving device configured to move the support member in a first direction, and a second moving device configured to move the support member in a second direction orthogonal to the first direction.

With this configuration, the first object supported on the placement surface can be moved to any position on the virtual plane simply by moving the support member in at least one of the first direction and the second direction.

In addition, as for a bonded object manufacturing apparatus according to a third aspect of the disclosure, the bonded object manufacturing apparatus according to the first aspect or the second aspect of the disclosure may include an angle-varying device configured to move the support member so as to change an angle of the placement surface along the virtual plane.

With this configuration, it is possible to correct an inclination of the first object placed at an angle with respect to the placement surface within the virtual plane.

In addition, as for a bonded object manufacturing apparatus according to a fourth aspect of the disclosure, in the bonded object manufacturing apparatus according to any one of the first to third aspects of the disclosure, the controller may be configured to cause the camera to image the first object while moving the support member relative to the camera, so that the camera captures images of a plurality of portions of the first object placed on the placement surface. Here, moving the support member relative to the camera typically includes moving at least one of the camera or the support member.

With this configuration, it is possible to confirm the deviation of the first object from the standard position at a plurality of locations and to improve the accuracy of position correction.

In addition, as for a bonded object manufacturing apparatus according to a fifth aspect of the disclosure, in the bonded object manufacturing apparatus according to any one of the first to fourth aspects of the disclosure, the camera may be configured to image a part of the first object supported on the placement surface located at the imaging position, and the apparatus may include a camera drive mechanism configured to move the camera so that the camera can image a plurality of portions of the first object supported on the placement surface located at the imaging position.

With this configuration, a plurality of portions of the first object can be imaged by a single camera.

In addition, as for a bonded object manufacturing apparatus according to a sixth aspect of the disclosure, in the bonded object manufacturing apparatus according to any one of the first to fourth aspects of the disclosure, a position of the camera may be fixed, the imaging position may include a first imaging position and a second imaging position different from the first imaging position, and the controller may be configured to move the moving device such that the placement surface passes through the first imaging position and the second imaging position.

With this configuration, a plurality of locations of portions of the first object can be imaged by a single camera.

In addition, as for a bonded object manufacturing apparatus according to a seventh aspect of the disclosure, the bonded object manufacturing apparatus according to any one of the first to sixth aspects of the disclosure may further include a vacuum chamber that accommodates the stage, in which the camera may be disposed outside the vacuum chamber.

With this configuration, a non-vacuum-compatible camera can be used, and the configuration of the camera can be simplified.

In addition, as for a method for manufacturing a bonded object according to an eighth aspect of the disclosure, the bonded object being formed by bonding a first object and a second object together, using the bonded object manufacturing apparatus according to any one of the first to seventh aspects, the method may include: a step of placing the first object on the placement surface at the placement position; a step of imaging, with the camera, the first object supported on the placement surface at the imaging position; a step of determining, by the controller, the deviation of the first object imaged by the camera from the standard position; a step of moving the placement surface to the transfer position after correcting the determined deviation so that the first object comes to the proper position at the transfer position; a step of transferring the first object supported on the placement surface to the stage at the transfer position; and a step of bonding the second object to the first object supported by the stage.

With this configuration, the bonded object can be manufactured without removing the first object from the support member during the period from when the first object is supported by the support member to when it is transferred to the stage, thereby improving manufacturing efficiency.

### Advantageous Effects of Invention

According to the disclosure, it is possible to detect and correct a positional deviation of the first object and transfer the first object to the stage without removing the first object from the support member during the period from when the first object is supported by the support member to when it is transferred to the stage.

### BRIEF DESCRIPTION OF DRAWINGS

Fig. 1 is a schematic configuration diagram of a bonded object manufacturing apparatus according to an embodiment.
Fig. 2 is a schematic side view of a moving device included in the bonded object manufacturing apparatus according to the embodiment.
Fig. 3 is a schematic side sectional view showing a configuration of a bonding device included in the bonded object manufacturing apparatus according to the embodiment.
Fig. 4 is a diagram illustrating an example of coordinates set in a controller.
Fig. 5 is a flowchart illustrating a procedure of manufacturing a bonded object according to an embodiment.

### DESCRIPTION OF EMBODIMENTS

This application is based on Japanese Patent Application No. 2023-087197 filed on May 26, 2023 in Japan, the contents of which are hereby incorporated in its entirety by reference into the present application, as part thereof.

The present invention will also be more fully understood from the detailed description given hereinbelow. Further range of application of the present invention will be apparent from the detailed description given hereinbelow. However, the detailed description and the specific examples are preferred embodiments of the invention and are described only for the purpose of explanation. From this detailed description, various changes and modifications will be apparent to those skilled in the art within the spirit and scope of the invention.

The applicant has no intention of giving any of the described embodiments to the public, and among the disclosed modifications and alternatives, modifications and alternatives that may not be included in the scope of the claims are also included in the invention under the doctrine of equivalents.

Hereinafter, embodiments will be described with reference to the drawings. In the drawings, the same or corresponding members are denoted by the same or similar reference numerals, and redundant description is omitted.

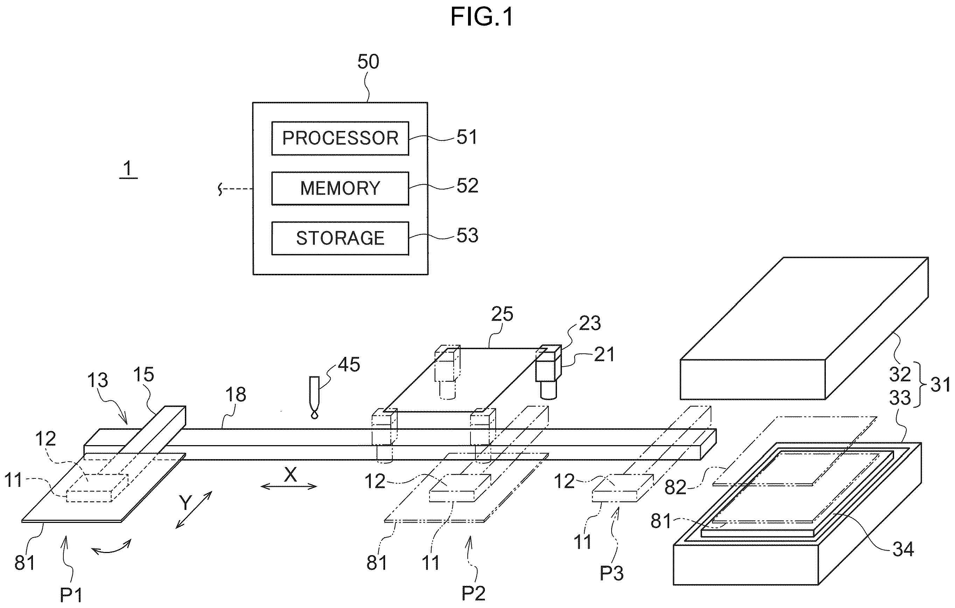

First, with reference to Fig. 1, a bonded object manufacturing apparatus 1 according to an embodiment will be described. Fig. 1 is a schematic configuration diagram of a bonded object manufacturing apparatus 1. The bonded object manufacturing apparatus 1 is an apparatus that manufactures a bonded object in which a first object (hereinafter referred to as a "first object 81") and a second object (hereinafter referred to as a "second object 82") are bonded to each other with a resin interposed therebetween. Each of the first object 81 and the second object 82 may be, for example, a substrate of a liquid crystal display, a lens, or the like. The first object 81 may be a liquid crystal module. The liquid crystal module as the first object 81 may be formed in a rectangular flat plate shape. The second object 82 may be a cover glass for protecting the liquid crystal. The cover glass as the second object 82 may be formed in a rectangular flat plate shape. The resin supplied between the first object 81 and the second object 82 may serve as an adhesive. In the present embodiment, the resin may be in a liquid state having a predetermined viscosity and fluidity when applied to the first object 81 and/or the second object 82, and may be cured when the first object 81 and the second object 82 are bonded together and a viscosity-increasing process is applied. Depending on the properties of the resin, examples of the viscosity-increasing process include irradiation with ultraviolet rays, heating, and allowing time to elapse.

Once manufacturing a bonded object starts, the bonded object manufacturing apparatus 1 commonly handles, for both the first object 81 and the second object 82, objects having the same material, shape, and size , and manufactures a plurality of identical bonded objects for the time being. The bonded object manufacturing apparatus 1 can handle the first object 81 and/or the second object 82 having a different material and/or a different shape and/or a different size from those previously used, by changing its settings. When manufacturing the bonded object, alignment is performed in order to bond the first object 81 and the second object 82 to each other at appropriate positions. In the bonded object manufacturing apparatus 1 according to the present embodiment, the configuration for alignment has been simplified compared with that of the related art. The bonded object manufacturing apparatus 1 includes a support member 11, a moving device 13, a camera 21, a stage 34, and a controller 50.

The support member 11 is a member that supports the first object 81. The support member 11 has a placement surface 12 that supports the first object 81 in a surface contact manner. In the present embodiment, the placement surface 12 is formed to have a flat surface to conform to the first object 81 that is formed in a rectangular flat plate shape. Although the shape of the placement surface 12 may be any shape that can support the first object 81 in a surface contact manner, such as a quadrangular or other polygonal shape, a circular shape, or an elliptical shape. The placement surface 12 in the present embodiment is formed in a rectangular shape. The size of the placement surface 12 may be the same as, larger than, or smaller than the surface area of the first object 81. However, from the viewpoint of placement stability, it is preferable that the size of the placement surface 12 be 0.2 times or more, or 0.3 times or more, of the surface area of the first object 81, and from the viewpoint of suppressing an increase in size, it is preferable that the size be 1.5 times or less. In the present embodiment, the support member 11 is disposed such that the placement surface 12 extends horizontally.

In the present embodiment, from the viewpoint of stably supporting the first object 81, the support member 11 preferably supports the first object 81 such that the centroid of the rectangular first object 81 coincides with the centroid of the rectangular placement surface 12, and the outer peripheral side of the first object 81 is parallel to the corresponding outer peripheral side of the placement surface 12. Accordingly, in the present embodiment, a state in which such a positional relationship between the placement surface 12 and the first object 81 is referred to as a state in which the first object 81 is placed at a standard position on the placement surface 12. The standard position is a concept used in alignment when manufacturing a bonded object, and represents the position of the first object 81 on the placement surface 12. Although any position can be set, in the present embodiment, the above position is set as the standard position. The support member 11 according to the present embodiment is also configured to support the second object 82 in the same manner as the first object 81.

The moving device 13 is a device that moves the support member 11. The moving device 13 in the present embodiment moves the support member 11 such that the placement surface 12 moves on a virtual plane. The virtual plane is an imaginary plane that lies on the same plane as the placement surface 12. In the present embodiment, since support member 11 is disposed such that placement surface 12 extends horizontally, the virtual plane also extends horizontally. In other words, the virtual plane in the present embodiment is a horizontal plane that extends outside (around) the placement surface 12 at the same height as the placement surface 12.

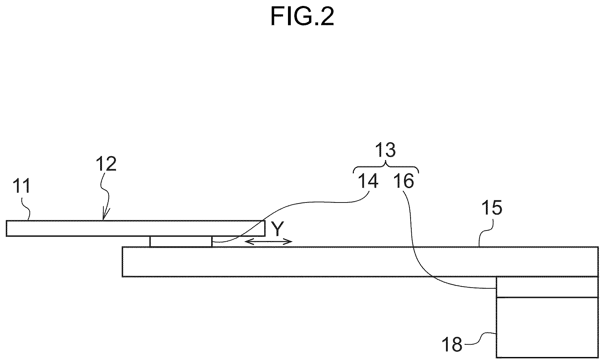

As will be further understood with reference also to Fig. 2, the moving device 13 in the present embodiment includes a first moving device (hereinafter referred to as a "first moving device 14") and a second moving device (hereinafter referred to as a "second moving device 16"). The first moving device 14 moves the support member 11 in a first direction (hereinafter referred to as a "Y direction"). The first moving device 14 reciprocates linearly on an elongated arm 15 extending in the Y direction. The first moving device 14 may employ a linear servo motor. The first moving device 14 is disposed on the arm 15 and under the support member 11. In other words, the first moving device 14 is disposed between the support member 11 and the arm 15. The first moving device 14 in the present embodiment can reciprocate rotationally within a horizontal plane (see Fig. 1). That is, the first moving device 14 in the present embodiment also serves as an angle-varying device that changes the angle of the support member 11 so that the placement surface 12 can reciprocate rotationally along the virtual plane.

The second moving device 16 moves the arm 15 in a second direction (hereinafter referred to as an "X direction"). The second moving device 16 reciprocates linearly on an elongated transport rail 18 extending in the X direction. The second moving device 16 may employ a linear servo motor. The second moving device 16 is disposed on the transport rail 18 and under the arm 15. In other words, the second moving device 16 is disposed between the arm 15 and the transport rail 18. The moving device 13 moves the arm 15 in the X direction by means of the second moving device 16, and moves the support member 11 in the Y direction by means of the first moving device 14 that moves on the arm 15. By moving the first moving device 14 and the second moving device 16 in this manner, the moving device 13 can move the placement surface 12 of the support member 11 to any position in the virtual plane within the movable range of the moving device 13.

The camera 21 captures an image of the first object 81 placed on the placement surface 12 of the support member 11. The camera 21 captures an image of the first object 81 in order to check the position where the first object 81 is placed on the placement surface 12. The camera 21 may typically employ a CCD camera or a CMOS camera. In the present embodiment, the camera 21 is provided above the movable range of the placement surface 12, and captures an image of the first object 81 placed on the placement surface 12 from above. From the viewpoint of accurately detecting the position of the first object 81, it is preferable that the camera 21 have an angle of view in which only a part of the first object 81 is included rather than the entirety of the first object 81. In the present embodiment, the camera 21 has an angle of view that includes a corner portion of the first object 81. When the camera 21 captures an image of a part of the first object 81, it is preferable, from the viewpoint of accurately detecting the position of the first object 81, that the camera 21 and the support member 11 be movable relative to each other so that the camera 21 can capture images of a plurality of portions of the first object 81. In the present embodiment, a camera drive mechanism 23 (hereinafter, simply referred to as a "drive mechanism 23") that moves the camera 21 is provided in the camera 21. The drive mechanism 23 can move along a camera rail 25. The camera rail 25 is typically supported by a frame (not illustrated) that supports a housing (not illustrated) of the bonded object manufacturing apparatus 1. The camera rail 25 is disposed in a rectangular annular shape corresponding to an outer periphery of the first object 81.

The stage 34 supports the first object 81 when the first object 81 and the second object 82 are bonded together. The stage 34 is accommodated in a chamber 31 in the present embodiment. The chamber 31 is a vacuum chamber in the present embodiment. The above-described camera 21 is disposed outside the chamber 31. Accordingly, the camera 21 does not require a vacuum-compatible specification, and can be implemented with a relatively simple configuration . It should be noted that the stage 34 illustrated in Fig. 1 is a conceptual illustration, and therefore the configuration around the stage 34 will be described separately.

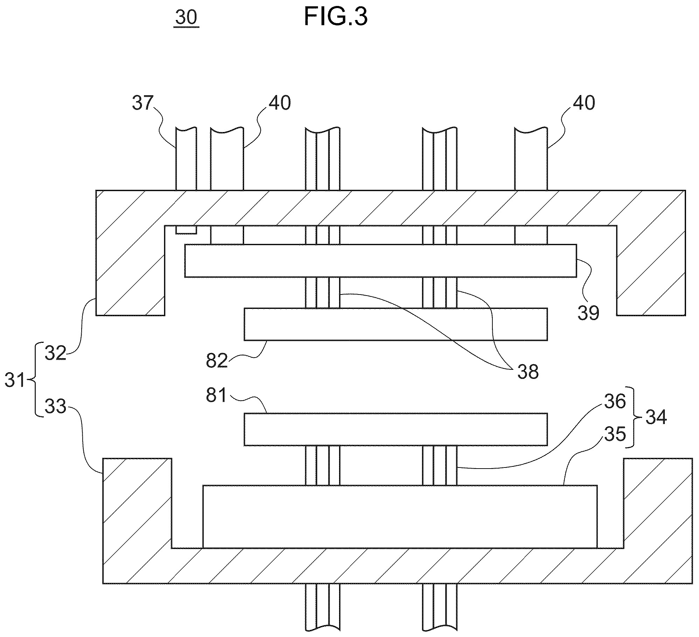

Fig. 3 is a schematic side sectional view illustrating the bonding device 30 included in the bonded object manufacturing apparatus 1 according to the present embodiment. The bonding device 30 includes the chamber 31 and the stage 34. The stage 34 is accommodated in the chamber 31 as described above. The chamber 31 includes a lid chamber 32 and a bottom chamber 33. The lid chamber 32 and the bottom chamber 33 are each provided with an outer peripheral wall. The outer peripheral wall of the lid chamber 32 extends downward from a lower surface of a plate-shaped member that is arranged to extend horizontally, and the outer peripheral wall of the bottom chamber 33 extends upward from an upper surface of a plate-shaped member that is arranged to extend horizontally. The chamber 31 is configured to be openable and closable by moving at least one of the lid chamber 32 or the bottom chamber 33 up and down. In the present embodiment, the bottom chamber 33 moves up and down. When the first object 81 and the second object 82 are loaded into or unloaded from the chamber 31, the lid chamber 32 and the bottom chamber 33 are separated from each other to form an open state, and when the first object 81 and the second object 82 are bonded to each other, the outer walls of the lid chamber 32 and the bottom chamber 33 come into contact with each other to form a closed state. The chamber 31 is configured to hermetically seal an internal space in the closed state.

In the present embodiment, the stage 34 includes a bottom plate 35 and lower support pins 36. The bottom plate 35 is a plate-shaped member having a surface of a size that covers the first object 81. The bottom plate 35 is provided on the upper surface of the plate-shaped member of the bottom chamber 33 such that the upper surface thereof is horizontal, and is configured to move up and down together with the up and down movement of the bottom chamber 33. The bottom plate 35 is typically made of a material harder than the first object 81. The lower support pins 36 include a plurality of elongated cylindrical members. The lower support pins 36 are disposed such that each cylindrical member extends vertically, and supports the lower surface of the first object 81 at the upper end thereof. The number and spacing of the cylindrical members constituting the lower support pins 36 may be determined from the viewpoint of stably supporting the first object 81, and in the present embodiment, four cylindrical members are disposed at positions closer to the centroid of the first object 81 than four corner portions of the first object 81. Each cylindrical member constituting the lower support pins 36 extends through the bottom plate 35 and the bottom chamber 33 to the outside of the chamber 31. Sealing members are provided at a portion where the cylindrical members constituting the lower support pins 36 penetrate the bottom plate 35 and the bottom chamber 33, so that hermetic sealing of the internal space of the chamber 31 in the closed state is maintained. An end portion of each cylindrical member of the lower support pins 36 located outside the chamber 31 is connected to a vacuum pump (not illustrated) via a pipe (not illustrated). When the lower surface of the first object 81 is supported by the upper end portions of the cylindrical members constituting the lower support pins 36, the inside of each cylindrical member is depressurized by the operation of a vacuum pump, so that the lower support pins 36 can hold the first object 81 by suction.

Upper support pins 38 and a press plate 39 are also provided in the chamber 31. The upper support pins 38 hold the second object 82 by suction. The upper support pins 38 include a plurality of elongated cylindrical members, similarly to the lower support pins 36. Each cylindrical member constituting the upper support pins 38 is disposed to extend vertically, penetrates the lid chamber 32, and has an upper end portion located outside the chamber 31. Sealing members are provided at a portion where the cylindrical members constituting the upper support pins 38 penetrate the lid chamber 32, so that hermetic sealing of the internal space of the chamber 31 in the closed state is maintained. An end portion of each cylindrical member of the upper support pins 38 located outside the chamber 31 is connected to a vacuum pump (not illustrated) via a pipe (not illustrated). When the upper surface of the second object 82 is in contact with the lower ends of the cylindrical members of the upper support pins 38 and the vacuum pump is operated, the upper support pins 38 can hold the second object 82 by suction. The number and spacing of the cylindrical members constituting the upper support pins 38 may be determined from the viewpoint of stably holding the second object 82, and in the present embodiment, the same number of cylindrical members as the cylindrical members of the lower support pins 36 are arranged at the same intervals.

The press plate 39 presses the second object 82 toward the first object 81 when the first object 81 and the second object 82 are bonded together. The press plate 39 is a plate-shaped member having a surface of a size that covers the second member 82, and is disposed above the bottom plate 35 such that its surface faces the surface of the bottom plate 35, typically inside the lid chamber 32. Each cylindrical member of the upper support pins 38 penetrates the press plate 39. The press plate 39 is provided with support rods 40 that support the press plate 39. The support rods 40 penetrate the lid chamber 32. Sealing members are provided at a portion where the support rods 40 penetrate the lid chamber 32. The support rods 40 are connected to a movement mechanism (not illustrated), and thus the press plate 39 can be moved up and down by operating the movement mechanism. In addition, a pipe 37 connected to a vacuum pump (not illustrated) also penetrates the lid chamber 32, and the inside of the sealed chamber 31 can be evacuated by operating the vacuum pump. The portion where the pipe 37 penetrates the lid chamber 32 is also sealed. When referring to the configuration around the stage 34 hereinafter, reference will be made to Fig. 3 as appropriate.

Referring again mainly to Fig. 1, the description of the bonded object manufacturing apparatus 1 will be continued. As described above, the placement surface 12 of the support member 11 is moved in the virtual plane by the moving device 13. In the present embodiment, the movable placement surface 12 is configured to temporarily stop at a placement position P1, an imaging position P2, and a transfer position P3. Here, the placement position P1 is a position where the first object 81 is placed on the placement surface 12, or in other words, a position where the placement surface 12 receives the first object 81. At the placement position P1, typically, a robot hand (not illustrated) places the first object 81 on the placement surface 12. The imaging position P2 is a position where the camera 21 images the first object 81 placed on the placement surface 12, and is typically a position below the camera rail 25. The transfer position P3 is a position where the first object 81 placed on the placement surface 12 is transferred to the stage 34, and is typically a position adjacent to the chamber 31. At the transfer position P3, typically, a robot hand (not illustrated) moves the first object 81 from the placement surface 12 to the stage 34. The robot hand provided at the transfer position P3 is configured to move the first object 81 from the transfer position P3 to the stage 34 by a predetermined distance. Accordingly, the position of the first object 81 at the transfer position P3 is reflected in the position of the first object 81 when it is transferred to the stage 34. In other words, if the position of the first object 81 at the transfer position P3 deviates from the proper position, the position of the first object 81 transferred to the stage 34 will also deviate from the aligned state with the second object 82 when they are bonded together. Here, the "proper position" refers to a position of the first object 81 at the transfer position P3, at which the first object 81, when transferred from the transfer position P3 to the stage 34 by the robot hand provided at the transfer position P3, comes to a state where it is aligned with the second object 82. In other words, the proper position refers to a position of the first object 81 at the transfer position P3, which is obtained by assuming that the robot hand provided at the transfer position P3 moves the first object 81, which is aligned with the second object 82, in the reverse direction-that is, from the stage 34 toward the support member 11-by a predetermined distance. The placement position P1, the imaging position P2, and the delivery position P3 described above are all the positions of the placement surface 12 on the virtual plane. It is to be noted that the placement position P1 is typically set at a position different from the imaging position P2; however, the placement position P1 may also be set at the same position as the imaging position P2 so that the first object 81 is imaged at the placement position P1.

When the first object 81 is placed at the standard position on the placement surface 12 at the placement position P1, the support member 11 (placement surface 12) that moves by the moving device 13 only needs to move in the X direction so that the first object 81 is brought into the proper position at the transfer position P3. In this case, the support member 11 is not moved in the Y direction, and the placement surface 12 is not rotated within the virtual plane. As such, the trajectory of the placement surface 12, in which the support member 11 (and hence the placement surface 12) is moved only in the X direction without movement in the Y direction and or rotation of the placement surface 12 within the virtual plane, is referred to as a "normal trajectory". If the first object 81 is placed at the standard position on the placement surface 12 at the placement position P1, the bonded object manufacturing apparatus 1 can place the first object 81 at the proper position at the transfer position P3 simply by moving the placement surface 12 (that is, the support member 11) on the normal trajectory. However, if the first object 81 is placed at a position deviating from the standard position on the placement surface 12 at the placement position P1, the first object 81 cannot be placed at the proper position at the transfer position P3 simply by moving the placement surface 12 on the normal trajectory. Therefore, in the bonded object manufacturing apparatus 1 according to the present embodiment, without using a dedicated automatic alignment stage, the controller 50 determines a deviation of the first object 81 from the standard position based on an image captured by the camera 21, and corrects the deviation before the first object 81 is transferred to the transfer position P3.

The controller 50 is a device that controls an operation of the bonded object manufacturing apparatus 1. The controller 50 is electrically connected (via a wired or wireless connection, the same shall apply hereinafter) to the moving device 13, and controls the moving device 13 so as to move the support member 11 in the X direction, move it in the Y direction, and rotate the placement surface 12 within the virtual plane. In addition, the controller 50 is electrically connected to the camera 21, and controls the camera 21 to capture an image and to transmit the image captured by the camera 21 to the controller 50 as data. The controller 50 is also electrically connected to the drive mechanism 23, and controls the drive mechanism 23 to move the camera 21 along the camera rail 25. The controller 50 is further electrically connected to the robot hands (not illustrated) provided at each of the placement position P1 and the transfer position P3, and controls an operation of each robot hand. The controller 50 is also electrically connected to the chamber 31, and controls the chamber 31 to move the bottom chamber 33 (and hence the bottom plate 35) up and down. The controller 50 is further electrically connected to the vacuum pump (not illustrated) connected to each of the lower support pins 36 and the upper support pins 38, and controls the vacuum pump to determine whether or not the first object 81 and the second object 82 are held by the lower support pins 36 and the upper support pins 38. The controller 50 is also electrically connected to the vacuum pump (not illustrated) connected to the pipe 37, and controls the vacuum pump to adjust the degree of vacuum in the chamber 31 through an operation of the vacuum pump. In addition, the controller 50 is electrically connected to the movement mechanism (not illustrated) connected to the press plate 39 via the support rods 40, and controls the movement mechanism to move the press plate 39 up and down.

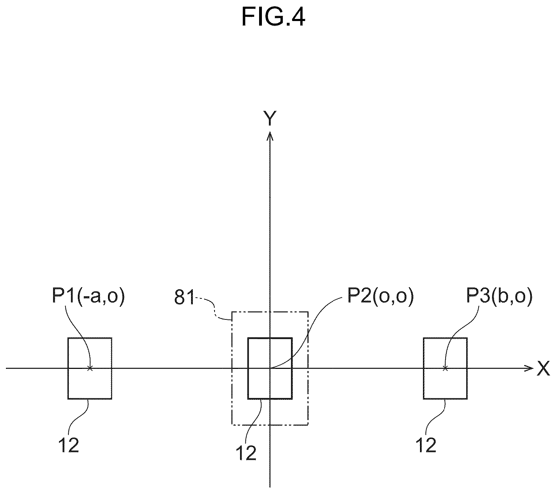

As illustrated in Fig. 4, in the present embodiment, the controller 50 assigns XY coordinates to the virtual plane so that any position on the virtual plane can be specified by coordinates. These coordinates are preferably set such that the trajectory of the centroid of the placement surface 12, which moves along the normal trajectory, coincides with the X-axis. The origin of the coordinates may be freely set in the present embodiment, the centroid of the placement surface 12 when the placement surface 12 is located at the imaging position P2 is set as the origin. That is, the coordinates of the centroid of the placement surface 12 located at the imaging position P2 are (0,0). In the present embodiment, the coordinates of the centroid of the placement surface 12 are (-a, 0) when the placement surface 12 is located at the placement position P1, and are (b, 0) when the placement surface 12 is located at the transfer position P3. In addition, controller 50 stores in advance the position of the first object 81 placed at the standard position on the placement surface 12 at the imaging position P2. In this case, typically, the coordinates of a plurality of points on the outer peripheral edge of the first object 81 are stored, so that the position of the first object 81 placed at the standard position on the placement surface 12 at the imaging position P2 is stored in the controller 50. The points on the outer peripheral edge of the first object 81 stored in the controller 50 may continuously represent the entire outer periphery of the first object 81, but two or more (for example, three or four) of the corner points of the first object 81 may be stored in advance.

The controller 50 can also compare the position of the first object 81 identified based on the imaging data received from the camera 21 with the position of the first object 81 stored in advance, and thereby determine a deviation of the position of the imaged first object 81 from the standard position. The controller 50 can identify the deviation of the imaged first object 81 from the standard position by assigning coordinates in advance to the image captured by the camera 21 at a specific position on the camera rail 25. The controller 50 may include at least one physical component selected from a processor 51, a memory 52 (a RAM and/or a ROM), and a storage 53. The controller 50 may also have a program for causing each device described above to operate properly, and may cause the processor 51 to execute the program.

In addition to the above constituents, the bonded object manufacturing apparatus 1 is provided with a resin supply device 45. The resin supply device 45 supplies (typically applies) a resin to the first object 81 and/or the second object 82. The resin may be supplied between the placement position P1 and the transfer position P3, and in the present embodiment, it is supplied between the placement position P1 and the imaging position P2. That is, the bonded object manufacturing apparatus 1 is provided with the resin supply device 45 between the placement position P1 and the imaging position P2. The resin supply device 45 is also electrically connected to the controller 50. The controller 50 controls the resin supply device 45 to start and stop the supply of the resin from the resin supply device 45 at appropriate timing.

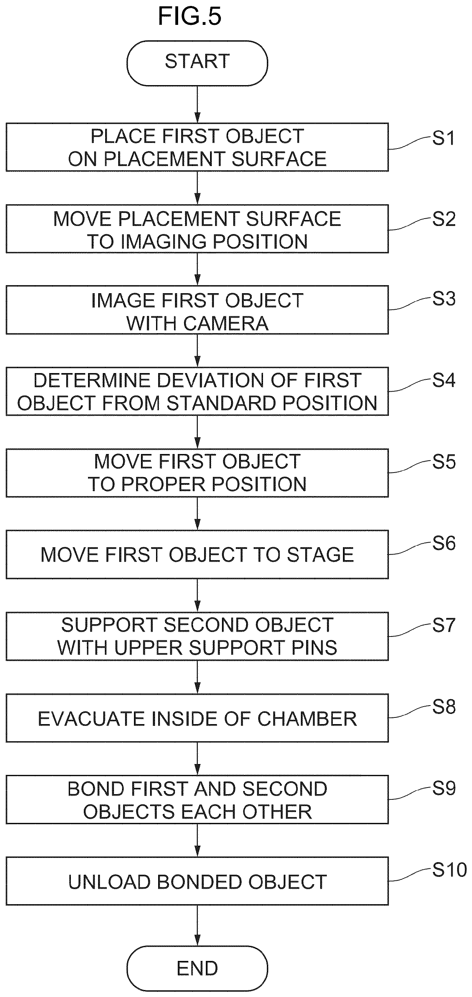

Next, with reference to Fig. 5, a method for manufacturing a bonded object will be described. Fig. 5 is a flowchart illustrating a procedure of manufacturing a bonded object. The method for manufacturing a bonded object described below is executed by using the bonded object manufacturing apparatus 1 described above. The following description of the method for manufacturing a bonded object using the bonded object manufacturing apparatus 1 also serves as an explanation of the operation of the bonded object manufacturing apparatus 1. In the following description, when reference is made to the configuration of the bonded object manufacturing apparatus 1, Figs. 1 to 4 are referred to as appropriate. In the following method for manufacturing a bonded object, operations of each device and instrument constituting the bonded object manufacturing apparatus 1 are typically performed based on commands from the controller 50. The method for manufacturing a bonded object according to the present embodiment may be provided in the form of a program for causing the processor 51 of the controller 50, which controls each constituent of the bonded object manufacturing apparatus 1, to execute predetermined operations, or in the form of a non-transitory computer readable medium storing the program.

While the bonded object manufacturing apparatus 1 is stopped, the placement surface 12 of the support member 11 is typically at the placement position P1; however, the placement surface 12 may be moved to the placement position P1 when the bonded object manufacturing apparatus 1 is activated. In the present embodiment, once the manufacturing of the bonded object is started, a robot hand (not illustrated) takes out one of a plurality of first objects 81 stored in a stocker (not illustrated) and places it on the placement surface 12 at the placement position P1 (S1). In this case, it is ideal that the first object 81 is placed at the standard position on the placement surface 12; however, the first object 81 may be placed at a position deviating from the standard position. When the first object 81 is placed on the placement surface 12, the controller 50 controls the moving device 13 to move the placement surface 12 to the imaging position P2 (S2). At this time, if the imaging position P2 is set to be the same as the placement position P1, the amount of movement of the placement surface 12 becomes zero. Although detailed description is omitted, in the present embodiment, resin is supplied (applied) from the resin supply device 45 onto the surface of the first object 81 while the placement surface 12 moves from the placement position P1 to the imaging position P2.

When the placement surface 12 has moved to the imaging position P2, the controller 50 controls the camera 21 to capture an image of the first object 81 placed on the placement surface 12 (S3). At this time, the controller 50 controls the camera 21 to transmit the image captured by the camera 21 to the controller 50. As described above, in the present embodiment, the camera 21 captures an image of a part of the first object 81. Thus, in order for the camera 21 to capture images of a plurality of specific portions (typically, corner portions) of the first object 81, the controller 50 controls the drive mechanism 23 to move the camera 21 along the camera rail 25. The controller 50 controls the camera 21 to transmit each image captured at the plurality of locations to the controller 50.

When the controller 50 receives the images from the camera 21, the controller 50 compares the position of the first object 81 in the standard position on the placement surface 12, which has been stored in advance in the controller 50, with the position of the imaged first object 81, and determines a deviation of the imaged first object 81 from the standard position (S4). At this time, it is preferable to determine the deviation from the standard position by using coordinates set for computation in the controller 50, since the amount of deviation can be clearly specified. For example, on the coordinates set in the controller 50, it can be specified that the deviation of the imaged first object 81 from the standard position is (2, 3).

Next, the controller 50 controls the moving device 13 to move the placement surface 12 such that the first object 81 placed on the placement surface 12 is brought into the proper position at the transfer position P3 (S5). At this time, the controller 50 moves the placement surface 12 while correcting the amount of deviation of the first object 81 from the standard position determined in the previous step. For example, if the deviation of the first object 81 from the standard position determined in the previous step is (2, 3), when the placement surface 12 is moved from the imaging position P2 to the transfer position P3 along the normal trajectory, the first object 81 placed on the placement surface 12 is displaced from the proper position by (2, 3). Accordingly, while the placement surface 12 is moved from the imaging position P2 to the transfer position P3, the controller 50 controls the moving device 13 so that the placement surface 12 comes to a position deviating by (-2, -3) from the position that would be obtained when moving along the normal trajectory. In the above example, by moving the placement surface 12 in this manner, the first object 81 placed on the placement surface 12 is placed in the proper position at the transfer position P3. As described above, in the bonded object manufacturing apparatus 1 according to the present embodiment, the first object 81 placed on the placement surface 12 at the placement position P1 can be moved to the proper position at the transfer position P3 while correcting positional deviation, without being moved from the placement surface 12. Therefore, in the bonded object manufacturing apparatus 1, it is not necessary to provide a dedicated automatic alignment stage and transport arms arranged in front of and behind the alignment stage, whereby downsizing of the apparatus, reduction in cost, and simplification of the apparatus mechanism can be achieved.

After the first object 81 has been moved to the proper position, the controller 50 controls the robot hand (not illustrated) to move the first object 81 from the placement surface 12 of the support member 11 to the stage 34 (S6). At this time, the controller 50 controls the vacuum pump (not illustrated) fluidly connected to the interior of each cylindrical member of the lower support pins 36 to cause the lower support pins 36 to hold the first object 81 by suction. After the first object 81 is held by the lower support pins 36, the second object 82 is supported by the upper support pins 38 (S7). At this time, the second object 82 may also be placed on the placement surface 12, imaged by the camera 21 and its deviation from the standard position may be determined and corrected, so that the second object 82 can be moved to the proper position and held by suction by the upper support pins 38, in the same manner as the first object 81, by using the support member 11, the moving device 13, and the like. As a result, the second object 82 can also be supported in alignment with the upper support pins 38 with a simple configuration.

When the second object 82 has been supported by the upper support pins 38, the controller 50 controls the chamber 31 to close the chamber 31 by raising the bottom chamber 33, and controls the vacuum pump (not illustrated) fluidly connected to the pipe 37 to evacuate the inside of the chamber 31 (S8). After the inside of the chamber 31 is evacuated, the controller 50 controls the movement mechanism (not illustrated) indirectly connected to the press plate 39 to press the press plate 39 toward the bottom plate 35, thereby bonding the first object 81 and the second object 82 to each other (S9). The bonded object is manufactured by bonding the first object 81 and the second object 82 to each other. When the bonded object has been manufactured, the controller 50 controls the vacuum pump (not illustrated) to stop its operation and to restore the inside of the chamber 31 to the ambient environmental pressure, and also controls the chamber 31 to be opened and unload the bonded object from the chamber 31 (S10). Thus, one bonded object can be obtained. In a case in which the next bonded object is to be manufactured continuously, the above-described steps may be repeated.

As described above, according to the bonded object manufacturing apparatus 1 of the present embodiment, the first object 81 placed on the placement surface 12 at the placement position P1 can be moved to the proper position at the transfer position P3 while correcting the positional deviation, without being moved from the placement surface 12. Therefore, it is unnecessary to provide a dedicated automatic alignment stage and transport arms arranged in front of and behind the alignment stage, whereby downsizing of the apparatus, reduction in cost, and simplification of the apparatus mechanism can be achieved. Since the camera 21 is provided outside the chamber 31, it is not necessary to use a vacuum-compatible camera 21, and a relatively simple camera configuration can be adopted. In addition to the camera 21, the drive mechanism 23 and the camera rail 25 are provided, allowing the camera 21 to be moved along the camera rail 25. As described above, by allowing the camera 21 to be moved relative to the first object 81, a plurality of images can be obtained by capturing enlarged portions of the first object 81, and the position of the first object 81 can be accurately detected.

In the above description, a plurality of positions of the first object 81 are imaged by moving the camera 21 with respect to the first object 81 that is stationary at the imaging position P2. However, a plurality of positions of the first object 81 may be imaged by fixing the position of the camera 21 and moving the first object 81 placed on the placement surface 12 of the support member 11 by means of the moving device 13. In this case, it is preferable that the imaging position include, in addition to a first imaging position where the centroid of the placement surface 12 corresponds to the origin of the coordinates in the controller 50, a second imaging position where the centroid of the placement surface 12 corresponds to a position different from the origin of the coordinates in the controller 50. The second imaging position is a position where an image of a portion of the first object 81 different from the the portion imaged at the first imaging position can be obtained. The imaging positions may include, in addition to the first imaging position and the second imaging position, a third imaging position, a fourth imaging position, a fifth imaging position, and the like, at which images of other portions of the first object 81 can be obtained.

In the above description, the bonded object manufacturing apparatus 1 includes the chamber 31 capable of evacuating the inside thereof. However, if it is not necessary to bond the first object 81 and the second object 82 in a vacuum environment, the chamber 31 can be omitted. In this case, the transport rail 18 may be extended to the position of the lower support pins 36, and the transfer position P3 may be set at a position above the lower support pins 36, so that the lower support pins 36 can directly receive the first object 81 from the support member 11 without using the robot hand (not illustrated).

In the above description, the resin is supplied (applied) from the resin supply device 45 to the first object 81; however the resin may be supplied (applied) to the second object 82 instead of, or in addition to, the first object 81.

In the above description, the bonded object manufacturing apparatus and the method for manufacturing a bonded object according to the embodiment of the disclosure have been described mainly with reference to Figs. 1 to 5 as an example. However the configurations, structures, numbers, arrangements, shapes, materials, and the like of each portion are not limited to the above specific examples, and various modifications appropriately selected by those skilled in the art are also included within the scope of the invention as long as they fall within the spirit of the invention.

All references, including publications, patent applications, and patents, cited herein are hereby incorporated by reference to the same extent as if each reference were individually and specifically indicated to be incorporated by reference and were set forth in its entirety herein.

The use of the terms "a" and "an" and "the" and similar referents in the context of describing the invention (especially in the context of the following claims) is to be construed to cover both the singular and the plural, unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventors for carrying out the invention. Variations of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications and equivalents of the subject matter recited in the claims appended hereto as permitted by applicable law. Moreover, any combination of the above-described elements in all possible variations thereof is encompassed by the invention unless otherwise indicated herein or otherwise clearly contradicted by context.

## Claims

1. A bonded object manufacturing apparatus, comprising:
a support member having a placement surface, the placement surface being configured to support a first object on a surface thereof;
a camera configured to image the first object placed on the placement surface;
a stage configured to receive the first object from the support member and support the first object when the first object is bonded to a second object;
a moving device configured to move the support member such that the placement surface moves on a virtual plane identical to the placement surface, the moving device being configured to move the support member such that the placement surface passes through a placement position at which the first object is placed on the placement surface, an imaging position at which the first object is imaged by the camera, and a transfer position at which the first object is transferred to the stage; and
a controller configured to control movement of the support member by the moving device and imaging of the first object by the camera, wherein:
the controller has stored in advance a position of the first object placed at a standard position on the placement surface located at the imaging position, and the controller is configured to control the moving device and the camera such that the controller determines, based on imaging of the first object by the camera when the placement surface supporting the first object is located at the imaging position, a deviation of the first object from the standard position, and, when the placement surface has moved to the transfer position, the support member is moved to a position at which the deviation is corrected and the first object placed on the placement surface is positioned at a proper position, and
the proper position is a position of the first object when the placement surface supporting the first object at the standard position has reached the transfer position along a normal trajectory, the proper position being a position at which the first object, transferred from the support member to the stage and supported by the stage, is aligned with the second object.

2. The bonded object manufacturing apparatus according to claim 1, wherein the moving device includes a first moving device configured to move the support member in a first direction, and a second moving device configured to move the support member in a second direction orthogonal to the first direction.

3. The bonded object manufacturing apparatus according to claim 1 or 2, further comprising an angle-varying device configured to move the support member so as to change an angle of the placement surface along the virtual plane.

4. The bonded object manufacturing apparatus according to any one of claims 1 to 3, wherein the controller is configured to cause the camera to image the first object while moving the support member relative to the camera, so that the camera captures images of a plurality of portions of the first object placed on the placement surface.

5. The bonded object manufacturing apparatus according to claim 4, wherein:
the camera is configured to image a part of the first object supported on the placement surface located at the imaging position, and
the apparatus further comprises a camera drive mechanism configured to move the camera so that the camera can image a plurality of portions of the first object supported on the placement surface located at the imaging position.

6. The bonded object manufacturing apparatus according to claim 4, wherein:
a position of the camera is fixed,
the imaging position includes a first imaging position and a second imaging position different from the first imaging position, and
the controller is configured to move the moving device such that the placement surface passes through the first imaging position and the second imaging position.

7. The bonded object manufacturing apparatus according to any one of claims 1 to 6, further comprising a vacuum chamber that accommodates the stage,
wherein the camera is disposed outside the vacuum chamber.

8. A method for manufacturing a bonded object, the bonded object being formed by bonding a first object and a second object together, using the bonded object manufacturing apparatus according to any one of claims 1 to 7, the method comprising:
a step of placing the first object on the placement surface at the placement position;
a step of imaging, with the camera, the first object supported on the placement surface at the imaging position;
a step of determining, by the controller, the deviation of the first object imaged by the camera from the standard position;
a step of moving the placement surface to the transfer position after correcting the determined deviation so that the first object comes to the proper position at the transfer position;
a step of transferring the first object supported on the placement surface to the stage at the transfer position; and
a step of bonding the second object to the first object supported by the stage.
